# EUROPEAN PATENT SPECIFICATION

(11) **EP 3 534 549 B1**
(45) Date of publication and mention of the grant of the patent: **09.12.2026**
(21) Application number: 16919711.8
(22) Date of filing: 19.12.2016
(51) Int. Cl.: H04B 10/079, H04B 10/291

(54) **OPTICAL POWER AND GAIN DETECTION APPARATUS AND METHOD FOR OPTICAL AMPLIFIER IN BURST MODE**
VORRICHTUNG UND VERFAHREN ZUR DETEKTION VON OPTISCHER LEISTUNG UND VERSTÄRKUNG FÜR OPTISCHEN VERSTÄRKER IM BURST-MODUS
APPAREIL ET PROCÉDÉ DE DÉTECTION DE PUISSANCE OPTIQUE ET DE GAIN POUR AMPLIFICATEUR OPTIQUE EN MODE RAFALE

(30) Priority: 27.10.2016 CN 201610950093
(43) Date of publication of application: 04.09.2019
(73) Proprietor: Accelink Technologies Co., Ltd., Wuhan, Hubei 430205 (CN)
(72) Inventor: YU, Long, Wuhan Hubei 430205 (CN); ZHANG, Weiqing, Wuhan Hubei 430205 (CN); LI, CHunyu, Wuhan Hubei 430205 (CN); CHEN, ZHi, Wuhan Hubei 430205 (CN); YU, CHunping, Wuhan Hubei 430205 (CN); BO, Qinlian, Wuhan Hubei 430205 (CN)
(74) Representative: Frenkel, Matthias Alexander
(86) International application number: PCT/CN2016/110664
(87) International publication number: WO 2018/076501

(56) References cited:
- WO-A1-2007/134635
- WO-A1-2011/079656
- CN-A- 1 391 739
- CN-A- 101 141 204
- CN-A- 101 510 802
- CN-A- 102 324 969
- CN-A- 103 438 995
- US-A1- 2002 131 159
- US-A1- 2008 089 681
- US-A1- 2012 321 299
- US-A1- 2016 197 674

## Description

### TECHNICAL FIELD

The present disclosure relates to optical communication technology, and more particularly to improvement on an optical amplifier, and particularly to an apparatus and method for detecting optical power and gain of an optical amplifier in a burst mode. The present disclosure is used to solve a problem of detecting optical power and gain of an optical amplifier in the communication field, and is mainly used to accurately detect optical power and gain in a burst mode in the field of passive optical network for broadband optical fiber access.

### BACKGROUND

The access network is a bridge for users to enter a metropolitan area network/backbone network, and is the "last-mile network" of information transmission channel. With the development of internet and gradual emergence of high-bandwidth consumption services, bandwidth acceleration has become an urgent demand. In order to meet the demand of users, various new technologies are continuously emerging, and access network technology has become a research focus and an investment hotspot.

Among various broadband access technologies, a passive optical network (PON) has become a popular technology due to its advantages, such as large capacity, long transmission distance, low cost, and full-service support, etc. The PON system is a pure medium network, which avoids electromagnetic interference of external device and lightning effect, reduces the failure rate of line and external device, improves system reliability, and saves maintenance costs, accordingly, it is most widely used.

The PON system mainly includes an optical line terminal (OLT), an optical distribution network (ODN), and an optical network unit (ONU) at a local end. PON is a point-to-multipoint optical fiber transmission and access technology. Data from the OLT to the ONU transmits in a downstream direction, which uses a broadcast mode. Data from the ONU to the OLT transmits in an upstream direction, which uses time division multiple access (TDMA), i.e. a burst mode.

In order to extend an optical communication distance from the OLT to the ONU and improve a signal-to-noise ratio, an optical amplifier is usually added at the OLT side. For the downstream direction, a data rate transmitted by the OLT is much higher than detection bandwidth, and optical signal power is stable, and all of the conventional optical amplifiers may accurately detect optical power and gain. However, for the upstream direction, each ONU works in the burst mode, and only a data packet is transmitted, there will be an optical signal on an optical fiber; when there is no data, the ONU is in an idle state and does not transmit any optical signal, therefore, the optical signal over the optical fiber in the upstream direction is in the burst mode, which puts forward new requirements to the design of optical amplifier in the upstream direction, especially the power detection and the gain calculation.

Specifically, for detecting optical power, the conventional optical amplifier mainly includes a photoelectric converter, a trans-impedance amplifier, an ADC conversion chip, a single-chip microcomputer, and the like. The photoelectric converter converts an optical signal into a current signal, and the trans-impedance amplifier converts a current signal into a voltage signal, and the ADC conversion chip converts an analog voltage signal into a digital signal and transmits it to the single chip microcomputer. Since an operation speed of the single-chip microcomputer is slow, the single-chip microcomputer may detect the accurate optical power only when the optical power changes slowly. Since the single-chip microcomputer may only be operated in series, the input and output optical power cannot be simultaneously sampled, therefore, for the burst mode, accurate gain cannot be obtained.

In the prior art, the optical power and gain detection in the burst mode may be realized through both an analog aspect and a digital aspect, and different detection apparatuses and methods affect the detection cost and performance. For example, a patent "Receiving end light power on-line detection device and implementation method thereof" (Patent No. 201110200643.7) needs to add a BNC terminal and other acquisition modules on a universal ONU module, and an algorithm itself needs to add an additional trigger signal; a patent "Method and system for facilitating burst-mode optical power measurement" (Patent No. 200610093150.7) adopts a mode of adding a current mirror and a complicated analog circuit, which goes against its use in an optical amplifier. All of the implementation modes in the prior art need to modify the ONU module, and even modify the algorithm, which increases the complexity of the system design and does not meet the development requirements of the current broadband communication system.

A patent publication CN101510802A discloses a burst mode optical signal power measuring circuit. The burst mode optical signal power measuring circuit comprises a signal passage part and an optical power burst detecting part, wherein, in the signal passage part, optical current generates a burst detection signal by a photoelectric detector U3 via a trans-impedence amplifier U4 and a burst detection circuit U5, and the burst detection signal is used for triggering a time sequence generation circuit U6 to generate a control time sequence for maintaining sampling and carrying out digital-to-analog conversion; in the optical power burst detection part, an amplifying circuit U7 converts a mirror image current into a voltage signal; therefore, a sampling maintaining circuit U8 and a digital-to-analog conversion circuit U9 which are connected with the time sequence generation circuit can finish the burst detection of optical power under the control of the control time sequence. A microprocessor U10 transforms the corresponding voltage and an optical power for an adaptable gain. However, the burst mode optical signal power measuring circuit does not comprise an FPGA.

A patent publication US2012/0321299 A1 discloses an optical channel monitoring section, wherein the optical channel monitoring section includes multiple optical power detection path a-x, for example, an optical power detection path 1 comprises a photodiode 24a, a trans-impedance amplifier 25a, and an analog-to-digital converter 26a. The output of the multiple optical power detection paths are connected to a processing section 27.

A patent publication US 2002/0131159 A1 discloses a calibrated dynamic spectral filter, which does not related to the apparatus for detecting optical power and gain of an optical amplifier in a burst mode.

A patent publication WO 2011/079656 A1 discloses a device for obtaining optical power of optical network unit in online manner comprising an OLT side optical module. The OLT side optical module an optical detector, a preamplifier, a signal shaping circuit, an analog-digital converting circuit, and an E2PROM serially connected respectively.

A patent publication CN 102324969 A disclose a receiving end light power on-line detection device comprising a universal ONU (Optical Network Unit) module and a data acquisition and processing module. The universal ONU module comprises a photoelectric conversion circuit and an operational amplifying circuit, and an external BNC (Bayonet Nut Connector) terminal is additionally arranged on the universal ONU module and is connected with an output end of the operational amplifying circuit. The data acquisition and processing module comprises an operational amplifier, an ADC and an FPGA. The FPGA proceeds to S0 when the receiving end light power on-line detection device is powered. At S1, the FPGA decides whether the level of BNC signal is high or low. At S2, the FPGA informs the ADC chip to perform data sampling and analog-digital converting. At S3, the FPGA accumulates an obtained voltage value to the voltage sum of previously sampled voltage values. At S4, the FPGA performs an average for the accumulator to obtain an optical power.

A patent publication US 2008/0089681 A1 discloses a monitoring system for use in an optical transmission system comprises an optical amplifier, a coupler, an optical power detector, an A/D converter, a CPU, and a memory. The optical power detector has a function of detecting the optical power, using the optical branch signal from the coupler, and supplying it to the A/D convertor. The A/D converter has a function of converting the detected optical power into digital information for supply to the CPU, and the CPU of the control unit has a function of comparing the digital information of optical power with a predetermined threshold value prestored in the memory and issuing an alarm in accordance with the comparison result.

The present disclosure fully uses the design of current amplifier, and combines the advantages of digital circuit and FPGA device, and provides an apparatus and method for detecting optical power and gain of an optical amplifier in a burst mode; the present disclosure does not need to make any modifications to the ONU module, and may more adapt to the use of the current broadband communication system, meanwhile, the algorithm directly uses the sampled analog signal to process, and it does not need to add a trigger circuit on the hardware, which reduces the complexity of the system design.

### SUMMARY

In order to overcome some defects of detection for optical power and gain in existing optical amplifiers, the present disclosure proposes an apparatus and method for detecting optical power and gain in a burst mode.

The technical problem to be solved in the present disclosure is to implement detection for optical power and gain of an optical amplifier in a burst mode, mainly in a passive optical network, when the system polls input and output optical power and gain of an optical amplifier, the optical amplifier may timely and accurately report numerical values.

In order to solve the above technical problems, the present disclosure provides an apparatus for detecting optical power in a burst mode, comprising : An apparatus for detecting optical power and gain of an optical amplifier in a burst mode, comprising: multiple optical power detection circuits, an FPGA device, and a temperature detection circuit; wherein each optical power detection circuit adopts the same structure and implementation mode, and comprises a photoelectric converter (102), a trans-impedance amplifier, an analog signal conditioning circuit, a filter, an analog-digital conversion chip, which are respectively independent; in each optical power detection circuit, the photoelectric converter is configured to convert an optical signal of a respective optical path into a current signal, the trans-impedance amplifier is configured to convert the current signal output by the photoelectric converter into a voltage signal, the analog signal conditioning circuit is configured to correct the voltage signal output by the trans-impedance amplifier, amplify and translate the voltage signal to adjust the amplitude thereof to a range suitable for the analog-digital conversion chip, the filter is configured to filter out a high frequency interference signal in the voltage signal output by the analog signal conditioning circuit, the analog-digital conversion chip is configured to convert the filtered analog voltage signal into a digital signal and output the same to the FPGA device; the FPGA device is configured to calculate current optical power of each optical path from the digital signal input by the respective optical path, and to calculate gain of the optical amplifier from synchronized input optical power and output optical power; and wherein the FPGA device is provided with a timer and the FPGA device is configured to compare the optical power value calculated by the FPGA device with a preset threshold, and then indicate that what is detected by the sampling at this time is in a non-optical-signaled state and the data is invalid when the optical power value is less than the preset threshold; and compare the currently detected optical power value with the optical power value detected at last time, if the currently detected optical power value is less than the optical power value detected at last time, to indicate the current optical power value to be invalid, otherwise to indicate the current optical power value to be valid; when the current optical power is less than the threshold, the FPGA device is configured to start the timer, if a timing time exceeds a set value, update data of the optical power stored in a memory inside the FPGA device, and reset the timer; and when the current optical power is greater than the threshold, if an update command is received, the FPGA device is configured to update the data of the optical power stored in the memory inside the FPGA device; or when the current optical power is greater than the threshold and less than an optical power detected at last time, the FPGA device is configured to start the timer, if a timing time exceeds a set value, update the data of the optical power stored in the memory inside the FPGA device, and reset the timer; or when the current optical power is greater than the threshold and greater than the optical power detected at last time, the FPGA device is configured to perform a moving average on the current optical power with optical powers obtained from previous detections to obtain a current average optical power value, then update the data of the optical power stored in the memory inside the FPGA device with the current average optical power value, and reset the timer; and wherein the FPGA device is further configured to complete initialization of a variable and a storage space, and then enter a synchronization control state to ensure that a clock signal and a control signal of the analog-digital conversion chip in each optical power detection circuit are completely identical, such that each analog-digital conversion chip in each optical power detection circuit simultaneously samples, and strict synchronization clock is internally performed on the data, and input and output optical power is simultaneously obtained, the FPGA is further configured to determine validity of a detected input optical power and output optical power; when the detected input optical power or output optical power is less than a threshold, the FPGA device is further configured to indicate that an invalid value is detected, and start a timer of the FPGA; if a timing time is exceeded, update gain data and at the same time indicate a current gain value as invalid data, clear the timer, and perform a next gain detection process; and when the detected input optical power or output optical power is greater than the threshold, the FPGA device is further configured to indicate that a valid value is detected, and determine whether an update command is received, if the update command is received, update the gain data immediately, otherwise, calculate the gain of the optical amplifier from the input optical power and output optical power, store the gain data, perform a moving average, and update the gain data with data after performing the moving average, clear the timer, and perform a next gain detection process.

In the above technical solution, the temperature detection circuit comprises a temperature sensor which is configured to detect temperature of the optical amplifier and convert the detected temperature into a digital signal and then transmit the digital signal to the FPGA device, and the FPGA device is configured to compensate the obtained optical power and/or gain based on the detected temperature value.

In the above technical solution, the FPGA device further includes a communication interface for setting a power threshold, a time interval of a timer, and a temperature compensation coefficient.

In the above technical solution, the optical amplifier may be a Raman fiber amplifier, an erbium-doped fiber amplifier, an ytterbium-doped fiber amplifier, a hybrid fiber amplifier, or a high-power fiber amplifier.

In the above technical solution, the FPGA device is further configured to receive an analog signal detected by each optical power detection circuit which is converted into a digital signal by the analog-digital conversion chip and transmitted to the FPGA device, and calculate actual optical power based on a calibration coefficient prestored in a parameter table; when the actual optical power exceeds a set threshold, the FPGA device is configured to trigger a detection state machine inside the FPGA device, perform a moving average on valid optical power, record a valid value thereof, and perform a power determination at the same time; and only when an optical power value detected at this time exceeds an optical power value detected at last time, the FPGA device is configured to update a numerical value in a memory inside the FPGA device, otherwise, to abandon the optical power value detected at this time, thus it is ensured that what is stored in the memory inside the FPGA device is the maximum optical power value in the burst mode.

In the above technical solution, when the numerical value in the memory inside the FPGA device is updated, the FPGA device is configured to start the timer to time; and when a timing time exceeds a set value, or an update command is received by the FPGA device through the communication interface, the FPGA device is configured to update the numerical value in the memory inside the FPGA device again.

In the above technical solution, the FPGA device further includes a temperature compensation parameter table for compensating an optical power calculation by using temperature data input by the temperature detection circuit.

The present disclosure further provides a method for detecting optical power of an optical amplifier by the apparatus for detecting optical power and gain of the optical amplifier in a burst mode as stated above, comprising:
step 401, initializing an optical power detection module, in an initial state, configuring an analog-digital conversion chip in each optical power detection circuit by an FPGA device, and after the configuration is completed, proceeding to step 402;
step 402, starting ADC sampling, continuously sampling, and outputting converted optical power data to the FPGA device by an analog-digital conversion chip, proceeding to step 403;
step 403, reading, by the FPGA device, sampled data input by the analog-digital conversion chip, calculating, by the FPGA device, currently detected optical power, and proceeding to step 404;
step 404, determining whether to perform a data update operation by determining whether an update data command is received, if the update data command is received, proceeding to step 405, otherwise proceeding to step 406;
step 405, updating data with the current optical power value, and returning to step 404;
step 406, comparing the optical power value calculated by the FPGA device with a preset threshold, when the optical power value is less than the preset threshold, it indicating that what is detected by the sampling of at this time is a non-optical-signaled state, and the data is invalid, proceeding to step 407; when the optical power value exceeds the preset threshold, it indicating that what is detected by the sampling at this time is in an optical-signaled state, and proceeding to step 408;
step 407, starting an internal timer timing, and then proceeding to step 409;
step 408, comparing the currently detected optical power value with the optical power value detected at last time, if the currently detected optical power value is less than the optical power value detected at last time, the current optical power value being considered to be invalid, proceeding to step 407, otherwise, the current optical power value being considered to be valid, proceeding to step 410;
step 409, determining whether a timing time of the internal timer reaches a preset delay, if the preset delay is reached, proceeding to step 411, otherwise, proceeding to step 404;
step 410, performing a moving average on the currently detected optical power value with the optical power values obtained from previous N detections to obtain the current optical power value so as to reduce influence of noise interference, and then proceeding to step 411;
step 411, resetting the internal timer, and proceeding to step 405,

In the above technical solution, the FPGA device stores a temperature compensation coefficient table in form of a lookup table, obtains a compensation coefficient by looking up the lookup table according to temperature data input by a temperature detection circuit, and multiplies the compensation coefficient with the currently detected power to obtain an actual optical power value at the current temperature.

The present disclosure further provides a method for detecting gain of an optical amplifier by the apparatus for detecting optical power and gain of the optical amplifier in a burst mode as stated above, comprising:
completing, by a FPGA device, initialization of a variable and a storage space, and then entering, by the FPGA device, a synchronization control state to ensure that a clock signal and a control signal of an ADC analog-digital conversion chip in each detection circuit are completely identical, such that the ADC analog-digital conversion chip in an input channel and the ADC analog-digital conversion chip in an output channel operate in a simultaneous sampling state;
calculating, by the FPGA device, input optical power of the input channel and input optical power of the output channel, respectively, and then determining, by the FPGA device, validity of the detected input optical power and output optical power;
when the detected input optical power or the detected output optical power is less than a threshold, indicating that an invalid value is detected, and starting a timer; if a timing time is exceeded, updating gain data and at the same time indicating a current gain value as invalid data, and clearing the timer, and performing a next gain detection process;
when the detected input optical power or the detected output optical power is greater than the threshold, indicating that a valid value is detected, and determining whether an update command is received, if the update command is received, updating the gain data immediately, otherwise, calculating the gain of the optical amplifier from the input optical power and the output optical power, storing the gain data, performing a moving average, and updating the gain data with data after performing moving average, clearing the timer, and performing the next gain detection process.

The present disclosure further comprises a communication interface and a parameter table which are configured to dynamically control length, threshold size and temperature compensation coefficient of a timer. By adjusting various parameters, the precision and time requirements of detection are met.

The present disclosure further comprises simply copying a control module inside the FPGA device to realize multiple optical signals and gain circuits operate simultaneously, and the used external devices are significantly reduced.

The present disclosure achieved the following technical effects:
Firstly, adding a complicated analogue circuit is avoided, meanwhile, the influence caused by element inconsistency in an analogue control solution is also avoided. The requirement of consistency may be achieved for the device based on digital control solutions, only by a simple calibration.

Secondly, whether the optical signal is in a stable mode or in a burst mode, the algorithm may accurately and stably detect optical power with a wider application range. The internal storage data is always the latest and valid data, which reflects the optical signal over the fiber in real time and accurately. The amplifier gain is calculated more accurately through strictly controlling the sampling synchronism of ADC and delay of calculation.

Finally, a temperature detection circuit and a compensation coefficient are added to improve the detection precision of the system. The property of the FPGA device is fully used to perform multiple control without affecting performance.

### BRIEF DESCRIPTION OF THE DRAWINGS

FIG. 1 is a schematic diagram of a PON system.
FIG. 2 is a sampling diagram of a burst mode.
FIG. 3 is a structural principle diagram of an apparatus for detecting optical power and gain of an optical amplifier in a burst mode according to the present disclosure.
FIG. 4 is a schematic diagram of optical power detection.
FIG. 5 is a schematic diagram of gain control and calculation.
FIG. 6 is a schematic diagram of temperature compensation.

### Reference signs:

101 First optical power detection circuit
102 Photoelectric converter
103 Trans-impedance amplifier
104 Analog signal conditioning circuit
105 Filter
106 High-speed and high-precision ADC analog-digital conversion chip
107 FPGA device
108 Temperature detection circuit
109 Nth optical power detection circuit
201 OLT unit
202 Optical amplifier
203 ONU unit
204 Optical fiber connection line
301 Downstream direction
302 Upstream direction
303 Sampling

### DESCRIPTION OF EMBODIMENTS

In order to facilitate the understanding and implementation of the present disclosure by those skilled in the art, the present disclosure will be further described in detail below with reference to drawings and embodiments.

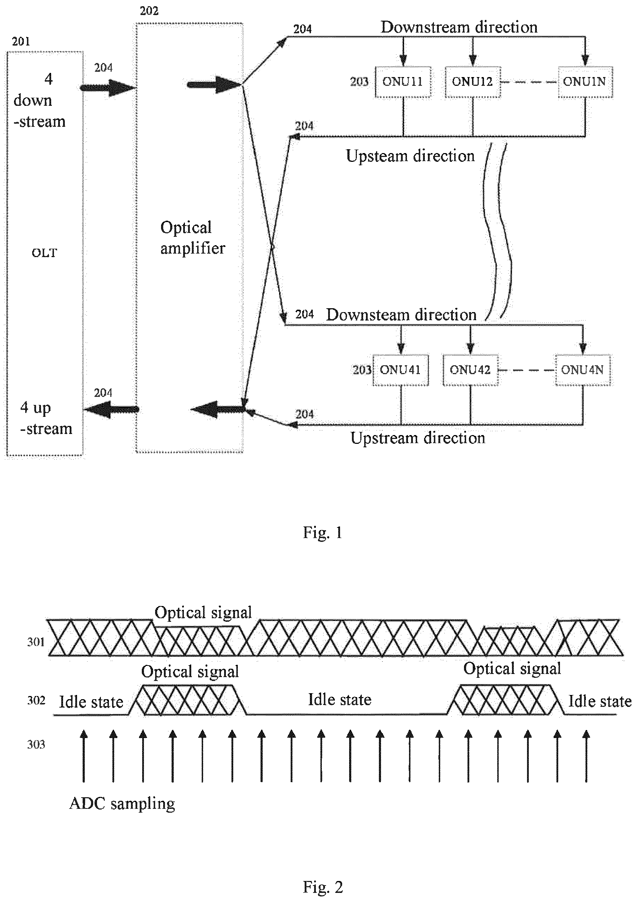

A typical PON system is simplified as shown in FIG. 1, and mainly includes: an OLT unit 201, an optical amplifier 202, a plurality of ONU units 203, and an optical fiber connection line 204; in order to increase a transmission distance and improve a signal-to-noise ratio, an optical amplifier 202 is provided between the OLT unit 201 and the ONU (i.e. the plurality of ONU units 203). Upstream ports and downstream ports of the OLT unit 201 are four ports, therefore, for the corresponding optical amplifier 202, it is also necessary to simultaneously support detection and amplification of four upstream signals and four downstream signals (i.e. required to support the detection and amplification of 8 signals). In the typical PON system, each downstream output terminal (4 downstream output terminals are shown in the figure, and other quantity is also possible) of the OLT unit 201 is connected to an input terminal of a corresponding optical path downstream amplification of the optical amplifier 202 through an optical fiber, an output terminal of a corresponding optical path downstream amplification of the optical amplifier 202 is connected to an input terminal of the plurality of ONU units 203 through an optical fiber, an output terminal of the plurality of ONU units is connected to an input terminal of a corresponding optical path upstream amplification of the optical amplifier 202, and an output terminal of a corresponding optical path upstream amplification of the optical amplifier 202 is connected to an input terminal of a corresponding optical path upstream amplification of OLT unit 201 through an optical fiber.

Detection and sampling of optical signal power of the optical amplifier 202 are shown in FIG. 2: for a downstream direction 301, since there is always an optical signal over the optical fiber, a change of the optical signal power is relatively slow, and for an upstream direction 302, when there is no data transmitted, there is no optical signal over the optical fiber, and it is in an idle state; when there is data service, an optical signal suddenly appears over the optical fiber. In order to convert the optical signal in the direction of the corresponding optical path into a voltage signal, the ADC chip in the optical amplifier 202 continuously performs ADC sampling 303. For the downstream direction 301, the valid optical power may always be sampled by the ADC chip, and the corresponding (suitable) optical power may always be read by the PON system (the OLT unit 201 therein) through a communication interface. For a burst mode of the optical signal in the upstream direction 302, if the PON system is not synchronized with the ADC sampling on the optical amplifier 202, it is possible to always read optical power of an idle state, i.e. invalid power. Since the optical power detected on the upstream optical path is invalid, the calculation, by the optical amplifier 202, of the internal gain of the corresponding upstream optical path may also be invalid. Further, temperature of the optical amplifier 202 itself changes during operating, and temperature compensation must also be considered in order to improve accuracy.

That is to say, the technical problem to be solved in the present disclosure is to implement detection for optical power and gain of an optical amplifier in a burst mode, especially in a passive optical network, when the PON system polls input and output optical power and gain of the optical amplifier, the optical amplifier may timely and accurately report numerical values.

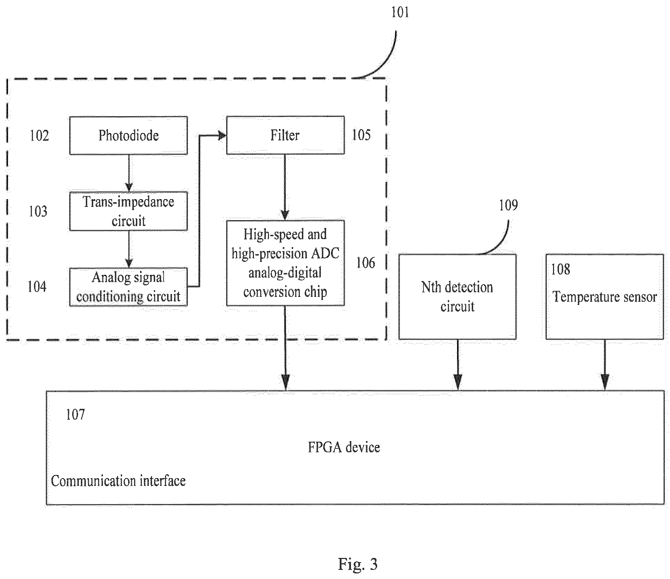

In order to solve the above technical problem, the present disclosure provides an apparatus for detecting optical power and gain of an optical amplifier in a burst mode, as shown in FIG. 3, comprising: multiple optical power detection circuits 101-109 and an FPGA device 107, a temperature detection circuit 108; wherein the first optical power detection circuit 101 to the N-th optical power detection circuit 109 adopt the same structure and implementation mode, and each comprises a photoelectric converter 102, a trans-impedance amplifier 103, an analog signal conditioning circuit 104, a filter 105, a high-speed and high-precision ADC analog-digital conversion chip 106 which are respectively independent.

Wherein, the photoelectric converter 102 in each optical power detection circuit is used to convert an optical signal of a corresponding optical path into a current signal, which may be implemented by using a photodiode; the trans-impedance amplifier 103 is used to convert the current signal output by the photoelectric converter 102 into a voltage signal; the analog signal conditioning circuit 104 is used to correct the voltage signal output by the trans-impedance amplifier 103, and amplify and translate the voltage signal to adjust the amplitude thereof to a range suitable for the high-speed and high-precision ADC analog-digital conversion chip 106; the filter 105 is used to filter out a high frequency interference signal in the signal output by the analog signal conditioning circuit 104 to improve the signal-to-noise ratio. The high-speed and high-precision ADC analog-digital conversion chip 106 converts the analog signal output by the analog signal conditioning circuit 104 into a digital signal and outputs the same to the FPGA device 107. The FPGA device 107 calculates optical power and gain of the corresponding optical path from digital signals input by each optical path (in modes of lookup table or index, logarithm operation, etc.). The temperature detection circuit 108 includes a temperature sensor provided on an optical amplifier. The temperature sensor is used to detect temperature of the optical amplifier, and convert the detected temperature into a digital signal and then transmitting the signal to the FPGA device 107, and the FPGA device 107 compensates the detected optical power/gain of the optical amplifier based on the detected temperature value. The FPGA device 107 further includes a communication interface for connecting the FPGA device 107 and the (PON) system to set a power threshold, a time interval of a timer, a temperature compensation coefficient, or other parameters and commands of the (PON) system.

The optical amplifiers targeted may be a Raman fiber amplifier, an erbium-doped fiber amplifier, an ytterbium-doped fiber amplifier, a hybrid fiber amplifier, and a high-power fiber amplifier, etc.

In a method for detecting optical power and gain on various optical paths in each direction of a PON system by using the apparatus for detecting optical power and gain provided by the present disclosure, an analog signal obtained through sampling in each optical power detection circuit is converted into a digital signal by the ADC analog-digital conversion chip 106 and transmitted to the FPGA device 107, and the FPGA device 107 calculates actual optical power based on a calibration coefficient prestored in a parameter table. And the power in milliwatt (mW) and decibel milliwatt (dBm) are obtained simultaneously for subsequent control needs by an index operation and a logarithmic operation. When the power exceeds a certain threshold, a detection state machine inside the FPGA device 107 is triggered. The FPGA device 107 performs a moving average on valid optical power, records the valid value at this time, and performs power determination at the same time. Only when the value detected at this time exceeds the detected value at last time, a numerical value in an internal memory is updated, otherwise, the value detected at this time will be abandoned, i.e. it is ensured that what is stored in the internal memory is the maximum value of the burst packet. A timer is provided inside the FPGA device 107. When the numerical value in the internal memory is updated, the timer starts timing. When a timing time exceeds a preset value, or an update command is received through the communication interface, the numerical value in the internal memory is updated again and the newly detected optical power is stored. The FPGA device 107 also includes a temperature compensation parameter table to improve detection precision of optical power.

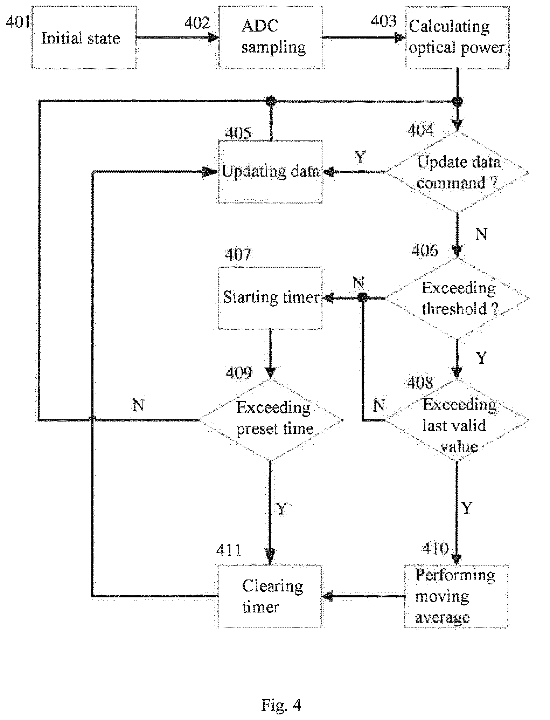

As shown in FIG. 4, the following steps are specifically included:
Step 401, initializing an optical power detection module. Immediately after power up or reset is completed, the optical power detection module is in an initial state, in which the FPGA device 107 configures the ADC analog-digital conversion chip 106, and after the configuration is completed, proceeding to step 402.

Step 402, performing ADC sampling. The ADC analog-digital conversion chip 106 continuously samples, i.e. entering an ADC sampling state.

Step 403, calculating optical power from an ADC sampling result. The FPGA device 107 reads the sampling data of the ADC analog-digital conversion chip 106, and calculates the optical power based on an algorithm or a look-up table.

Step 404, performing a data update operation by determining whether an update data command is received, proceeding to step 405 when the update data command is received, otherwise proceeding to step 406.

Proceeding to step 405 if the optical power detection module receives the update data command at this time; proceeding to step 406 if the optical power detection module does not receive the data update command at this time.

Step 405, updating data with a current optical power value, and returning to step 404.

Updating the data output by the corresponding optical power detection circuit with the optical power data calculated by the FPGA device 107, and then returning to step 404 to wait for starting a next data update process.

Step 406, determining whether the optical signal is detected, proceeding to step 407 when the optical signal is not detected, otherwise, proceeding to step 408.

Comparing the optical power value calculated by the FPGA device 107 with a preset threshold, when the optical power value is less than the preset threshold, it indicates that what is detected by the sampling at this time is in a non-optical-signaled state, and the data is invalid, proceeding to step 407; when the power value exceeds the preset threshold, it indicates that what is detected by the sampling at this time is in an optical-signaled state, proceeding to step 408.

Step 407, starting an internal timer timing, and then proceeding to step 409.

Step 408, determining whether the optical power value is valid, proceeding to step 407 when the optical power value is invalid, otherwise, proceeding to step 410.

Comparing the currently detected optical power value with the optical power value (valid value) detected at last time, if the currently detected optical power value is less than the optical power value detected at last time, the current optical power value is considered to be invalid, proceeding to step 407 to start the internal timer, otherwise, the current optical power value is considered to be valid, proceeding to step 410.

Step 409, determining whether a timing time of the timer reaches a preset delay, if the preset delay is reached, proceeding to step 411, otherwise, proceeding to step 404.

And accumulating the timing time after the internal timer is started, determining whether the accumulated timing time exceeds a preset time, proceeding to step 411 when the timing time of the timer exceeds the preset time, and proceeding to step 404 if the timer does not overflow.

Step 410, performing a moving average on the currently detected optical power value with the optical power value obtained from the previous N detections to obtain the current optical power value to reduce the influence of noise interference, and then proceeding to step 411, wherein N is 16-128 and may be dynamically adjusted according to the real-time requirements of the detection apparatus.

Step 411, resetting the internal timer, and proceeding to step 405.

Clearing the internal timer, and updating the data output by the corresponding optical power detection circuit with the currently detected optical power value, and proceeding to a next process.

Specifically, when no optical signal is transmitted for a long time on the corresponding optical path detected by the optical power detection circuit, the detected optical power will always be less than the preset threshold. Therefore, the delay is firstly performed by setting the timer to determine whether it is in a non-optical-signaled state for a short time, and when the timer overflows, it indicates that there is no light over the optical fiber for a long time, and the last valid value (valid value after performing the moving average) is no longer maintained, and the output data is updated with the current optical power value read at this time. By dynamically adjusting the length of timing of the timer, the actual state of the optical signal over the fiber may be reflected in real time; by dynamically adjusting the threshold size, the invalid power range is determined to meet different system requirements; from the above mode, the latest valid value detected is stored, a large number of invalid values are filtered, and the optical signal size of the service data over the optical fiber is accurately reflected.

The present disclosure also provides a method for detecting gain of an optical amplifier, comprising: simultaneously outputting a clock signal and a control signal on a hardware through a synchronous control logic by an FPGA device 107, such that an ADC analog-digital conversion chip 106 of each optical power detection circuit simultaneously samples, and strict synchronization clock is internally performed on the data, and input and output optical power is simultaneously obtained. An accurate gain is obtained by determining the validity of the optical power.

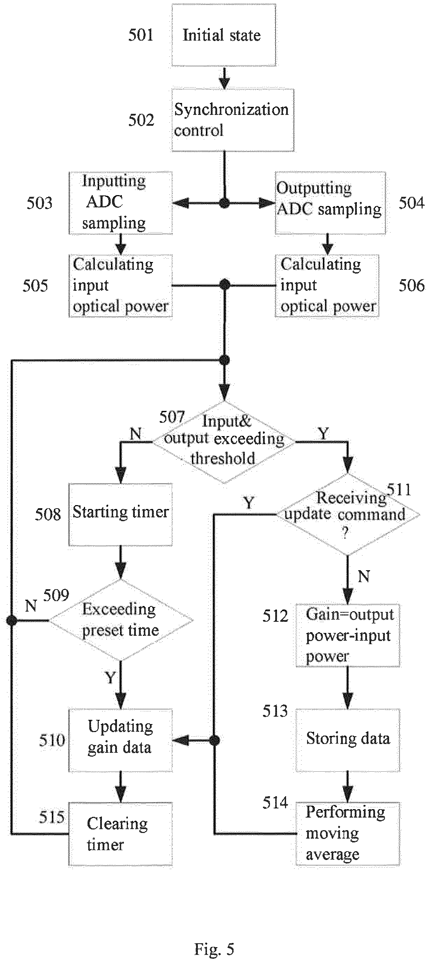

With reference to the flowchart described in FIG. 5, the method for detecting the gain by the FPGA device 107 will be further explained. Immediately after power up or reset is completed, the gain detection module in the FPGA device 107 is in an initial state 501, completing initialization of a variable and a storage space, and then proceeding to a synchronization control state 502, ensuring that the clock and control signals of the ADC analog-digital conversion chip 106 in each detection circuit are completely identical, such that the ADC analog-digital conversion chip in an input channel and the ADC analog-digital conversion chip in an output channel operate in the simultaneous sampling states 503, 504, calculating the input optical power of the input channel 505 and the input optical power of the output channel 506, respectively, and an internal algorithm of the FPGA device 107 ensures the synchronization of the calculation of the input optical power of the input channel and the input optical power of the output channel. Then determining the validity of the detected input optical power (i.e. the optical power input from the input channel) and the output optical power (i.e. the optical power input from the output channel) 507, i.e. whether the detected input and output optical power exceed a preset threshold. When the detected input optical power or output optical power is less than the preset threshold, it indicates that the detected input optical power or output optical power is an invalid value, and the timer is started 508. If a timing time is exceeded 509, gain data is updated 510, at the same time, a current gain value is indicated as invalid data, the timer is cleared 515, a next gain detection process is to be performed. When a valid value is detected, it is determined whether an update command is received 511. If the update command is received, the gain data is updated immediately 510, otherwise, the gain of the optical amplifier is calculated from the input optical power and the output optical power 512, the gain data is stored 513, the moving average is performed 514, the gain data is updated with the data after performing the moving average 510, and the timer is cleared 515, a next gain data calculation process is to be performed.

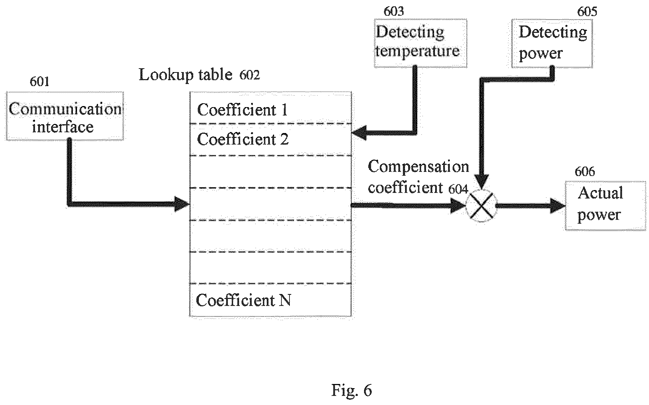

The temperature compensation method will be further explained with reference to the flowchart described in FIG. 6. The system configures a temperature compensation coefficient table 602 through a communication interface 601, and the temperature compensation coefficient table 602 is stored inside the FPGA device 107 in form of a lookup table. The temperature detection circuit obtains environment temperature 603 at the optical amplifier through the temperature sensor 108, and transmits the environment temperature data at the optical amplifier to the FPGA device 107. The FPGA device 107 obtains a compensation coefficient 604 by looking up the table according to the environment temperature data value, and multiplies the compensation coefficient 604 with the currently detected power 605 to obtain the actual optical power 606 at the current temperature, thus improving the accuracy of the system detection.

The present disclosure achieves multiple optical signals and gain circuits operate simultaneously by simply copying the control module in the FPGA device 107, and the external devices used may be significantly reduced.

The above embodiments are only one embodiment mode of the present disclosure, and the description thereof is more specific and detailed, but is not to be construed as limiting the scope of the present disclosure. The specific structure and size may be accordingly adjusted according to actual needs. It should be noted that a number of variations and modifications may be made by those skilled in the art without departing from the scope of the present disclosure, which is defined by the appended claims.

## Claims

1. An apparatus for detecting optical power and gain of an optical amplifier in a burst mode, comprising: multiple optical power detection circuits (101-109), an FPGA device (107), and a temperature detection circuit (108);
wherein each optical power detection circuit (101-109) adopts the same structure and implementation mode, and comprises a photoelectric converter (102), a trans-impedance amplifier (103), an analog signal conditioning circuit (104), a filter (105), an analog-digital conversion chip (106), which are respectively independent;
in each optical power detection circuit (101-109), the photoelectric converter (102) is configured to convert an optical signal of a respective optical path into a current signal, the trans-impedance amplifier (103) is configured to convert the current signal output by the photoelectric converter (102) into a voltage signal, the analog signal conditioning circuit (104) is configured to correct the voltage signal output by the trans-impedance amplifier (103), amplify and translate the voltage signal to adjust the amplitude thereof to a range suitable for the analog-digital conversion chip (106), the filter (105) is configured to filter out a high frequency interference signal in the voltage signal output by the analog signal conditioning circuit (104), the analog-digital conversion chip (106) is configured to convert the filtered analog voltage signal into a digital signal and output the same to the FPGA device (107); the FPGA device (107) is configured to calculate current optical power and gain of each optical path from the digital signal input by the respective optical path, and
wherein the FPGA device (107) is provided with a timer and the FPGA device (107) is configured to compare the optical power value calculated by the FPGA device (107) with a preset threshold, and then indicate that what is detected by the sampling at this time is in a non-optical-signaled state and the data is invalid when the optical power value is less than the preset threshold; and compare the currently detected optical power value with the optical power value detected at last time, if the currently detected optical power value is less than the optical power value detected at last time, to indicate the current optical power value to be invalid, otherwise to indicate the current optical power value to be valid;
when the current optical power is less than the threshold, the FPGA device (107) is configured to start the timer, if a timing time exceeds a set value, update data of the optical power stored in a memory inside the FPGA device (107), and reset the timer; and
when the current optical power is greater than the threshold, if an update command is received, the FPGA device (107) is configured to update the data of the optical power stored in the memory inside the FPGA device (107); or
when the current optical power is greater than the threshold and less than an optical power detected at last time, the FPGA device (107) is configured to start the timer, if a timing time exceeds a set value, update the data of the optical power stored in the memory inside the FPGA device (107), and reset the timer; or when the current optical power is greater than the threshold and greater than the optical power detected at last time, the FPGA device (107) is configured to perform a moving average on the current optical power with optical powers obtained from previous detections to obtain a current average optical power value, then update (405) the data of the optical power stored in the memory inside the FPGA device (107) with the current average optical power value, and reset the timer; and
wherein the FPGA device (107) is further configured to complete (501) initialization of a variable and a storage space, and then enter (502) a synchronization control state to ensure that a clock signal and a control signal of the analog-digital conversion chip (106) in each optical power detection circuit (101-109) are completely identical, such that each analog-digital conversion chip (106) in each optical power detection circuit (101-109) simultaneously samples, and strict synchronization clock is internally performed on the data, and input and output optical power is simultaneously obtained, the FPGA is further configured to determine (507) validity of a detected input optical power and output optical power;
when the detected input optical power or output optical power is less than a threshold, the FPGA device (107) is further configured to indicate that an invalid value is detected, and start (508) a timer of the FPGA; if a timing time is exceeded (509), update (510) gain data and at the same time indicate a current gain value as invalid data, clear (515) the timer, and perform a next gain detection process; and
when the detected input optical power or output optical power is greater than the threshold, the FPGA device (107) is further configured to indicate that a valid value is detected, and determine whether an update command is received (511), if the update command is received, update (510) the gain data immediately, otherwise, calculate (512) the gain of the optical amplifier from the input optical power and output optical power, store (513) the gain data, perform (514) a moving average, and update (510) the gain data with data after performing the moving average, clear (515) the timer, and perform a next gain detection process.

2. The apparatus for detecting optical power and gain of an optical amplifier in a burst mode of claim 1, **characterized in that**,
the temperature detection circuit (108) comprises a temperature sensor which is configured to detect temperature of the optical amplifier (202) and convert the detected temperature into a digital signal and then transmit the digital signal to the FPGA device (107), and
the FPGA device (107) is further configured to compensate the obtained optical power and/or gain based on the detected temperature value.

3. The apparatus for detecting optical power and gain of an optical amplifier in a burst mode of claim 1, **characterized in that**, the FPGA device (107) further includes a communication interface for setting a power threshold, a time interval of a timer, and a temperature compensation coefficient.

4. The apparatus for detecting optical power and gain of an optical amplifier in a burst mode of claim 1, **characterized in that**, the optical amplifier (202) is a Raman fiber amplifier, an erbium-doped fiber amplifier, an ytterbium-doped fiber amplifier, a hybrid fiber amplifier, or a high-power fiber amplifier.

5. The apparatus for detecting optical power and gain of an optical amplifier in a burst mode of claim 1, **characterized in that**,
the FPGA device (107) is further configured to receive an analog signal detected by each optical power detection circuit (101-109) which is converted into a digital signal by the analog-digital conversion chip (106) and transmitted to the FPGA device (107), and calculate actual optical power based on a calibration coefficient prestored in a parameter table;
when the actual optical power exceeds a set threshold, the FPGA device (107) is further configured to trigger a detection state machine inside the FPGA device (107), perform a moving average on valid optical power, record a valid value thereof, and perform a power determination at the same time; and only when a detected optical power value at this time exceeds an optical power value detected at last time, the FPGA device (107) is further configured to update a numerical value in a memory inside the FPGA device (107), otherwise, to abandon the detected optical power value at this time, so that it is ensured that what is stored in the memory inside the FPGA device (107) is the maximum optical power value in the burst mode.

6. The apparatus for detecting optical power and gain of an optical amplifier in a burst mode of claim 5, **characterized in that**, when the numerical value in the memory inside the FPGA device (107) is updated, the FPGA device (107) is configured to start the timer to time, and when a timing time exceeds a set value, or an update command is received by the FPGA device (107) through a communication interface, the FPGA device (107) is configured to update the numerical value in the memory inside the FPGA device (107) again.

7. The apparatus for detecting optical power and gain of an optical amplifier in a burst mode of claim 1, **characterized in that**, the FPGA device (107) further comprises a temperature compensation parameter table for using temperature data input by the temperature detection circuit (108) to compensate an optical power calculation.

8. A method for detecting optical power of an optical amplifier by the apparatus for detecting optical power and gain of the optical amplifier in a burst mode of any one of claims 1 to 7, **characterized in** comprising:
step 401, initializing an optical power detection module, in an initial state, configuring an analog-digital conversion chip (106) in each optical power detection circuit (101-109) by an FPGA device (107), and after the configuration is completed, proceeding to step 402;
step 402, starting ADC sampling, continuously sampling and outputting converted optical power data to the FPGA device (107) by the analog-digital conversion chip (106), proceeding to step 403;
step 403, reading, by the FPGA device (107), sampling data input by the analog-digital conversion chip (106), calculating, by the FPGA device (107), currently detected optical power, and proceeding to step 404;
step 404, determining whether to perform a data update operation by determining whether an update data command is received, if the update data command is received, proceeding to step 405, otherwise proceeding to step 406;
step 405, updating data with a current optical power value, and returning to step 404;
step 406, comparing the optical power value calculated by the FPGA device (107) with a preset threshold, when the optical power value is less than the preset threshold, indicating that what is detected by the sampling at this time is in a non-optical-signaled state and the data is invalid, proceeding to step 407; when the power value exceeds the preset threshold, indicating that what is detected by the sampling at this time is in an optical-signaled state, proceeding to step 408;
step 407, starting an internal timer timing, and then proceeding to step 409;
step 408, comparing the currently detected optical power value with the optical power value detected at last time, if the currently detected optical power value is less than the optical power value detected at last time, the current optical power value being considered to be invalid, proceeding to step 407, otherwise, the current optical power value being considered to be valid, proceeding to step 410;
step 409, determining whether a timing time of the internal timer reaches a preset delay, if the preset delay is reached, proceeding to step 411, otherwise, proceeding to step 404;
step 410, performing a moving average on the currently detected optical power value with the optical power value obtained from previous N detections to obtain the current optical power value to reduce influence of noise interference, and then proceeding to step 411;
step 411, resetting the internal timer, and proceeding to step 405 .

9. The method for detecting optical power of an optical amplifier in a burst mode of claim 8, **characterized in that**, the FPGA device (107) stores a temperature compensation coefficient table (602) in form of a lookup table, obtains a compensation coefficient (604) by looking up the temperature compensation coefficient table (602) according to temperature data input by a temperature detection circuit (108), and multiplies the compensation coefficient (604) with the currently detected power value (605) to obtain an actual optical power value (606) at the current temperature.

10. A method for detecting gain of an optical amplifier by the apparatus for detecting optical power and gain of the optical amplifier in a burst mode of any one of claims 1 to 7, **characterized in** comprising:
completing (501), by an FPGA device (107), initialization of a variable and a storage space, and then entering (502) by the FPGA device (107), a synchronization control state to ensure that a clock signal and a control signal of the ADC analog-digital conversion chip (106) in each optical power detection circuit (101-109) are completely
identical, such that each analog-digital conversion chip (106) in each optical power detection circuit (101-109) simultaneously samples, and strict synchronization clock is internally performed on the data, and input and output optical power is simultaneously obtained; determining (507), by the FPGA device (107), validity of a detected input optical power and output optical power;
when the detected input optical power or output optical power is less than a threshold, indicating that an invalid value is detected, and starting (508) a timer; if a timing time is exceeded (509), updating (510) gain data and at the same time indicating a current gain value as invalid data, clearing (515) the timer, and performing a next gain detection process;
when the detected input optical power or output optical power is greater than the threshold, indicating that a valid value is detected, and determining whether an update command is received (511), if the update command is received, updating (510) the gain data immediately, otherwise, calculating (512) the gain of the optical amplifier from the input optical power and output optical power, storing (513) the gain data, performing (514) a moving average, and updating (510) the gain data with data after performing the moving average, clearing (515) the timer, and performing a next gain detection process.

## Patentansprüche

1. Vorrichtung zum Erfassen optischer Leistung und Verstärkung eines optischen Verstärkers in einem Burst-Modus, umfassend: mehrere optische Leistungserfassungsschaltungen (101-109), ein FPGA-Gerät (107) und eine Temperaturerfassungsschaltung (108);
wobei jede optische Leistungserfassungsschaltung (101-109) den gleichen Aufbau und die gleiche Ausführungsmodus aufweist und einen photoelektrischen Wandler (102), einen Transimpedanzverstärker (103), eine analoge Signalaufbereitungsschaltung (104), ein Filter (105) sowie einen Analog-Digital-Wandler-Chip (106) umfasst, die jeweils unabhängig voneinander sind;
wobei in jeder optischen Leistungserfassungsschaltung (101-109) der photoelektrische Wandler (102) so konfiguriert ist, dass er ein optisches Signal eines jeweiligen optischen Pfades in ein Stromsignal umwandelt, und der Transimpedanzverstärker (103) so konfiguriert ist, dass er das von dem photoelektrischen Wandler (102) ausgegebene Stromsignal in ein Spannungssignal umwandelt, die analoge Signalaufbereitungsschaltung (104) so ausgelegt ist, dass sie das von dem Transimpedanzverstärker (103) ausgegebene Spannungssignal korrigiert, verstärkt und umwandelt, um dessen Amplitude auf einen für den Analog-Digital-Wandler-Chip (106) geeigneten Bereich einzustellen, das Filter (105) so ausgelegt ist, dass es ein hochfrequentes Störsignal aus dem von der analogen Signalaufbereitungsschaltung (104) ausgegebenen Spannungssignal herausfiltert, der Analog-Digital-Wandler-Chip (106) so konfiguriert ist, dass er das gefilterte analoge Spannungssignal in ein digitales Signal umwandelt und dieses an das FPGA-Gerät (107) ausgibt; das FPGA-Gerät (107) so konfiguriert ist, dass es die aktuelle optische Leistung und die Verstärkung jedes optischen Pfades aus dem von dem jeweiligen optischen Pfad eingegebenen digitalen Signal berechnet, und
wobei das FPGA-Gerät (107) mit einem Timer ausgestattet ist und das FPGA-Gerät (107) so ausgelegt ist, den von dem FPGA-Gerät (107) berechneten optischen Leistungswert mit einem voreingestellten Schwellenwert zu vergleichen und anschließend anzuzeigen, dass sich das, was bei der Abtastung zu diesem Zeitpunkt erfasst wird, in einem Zustand ohne optisches Signal befindet und die Daten ungültig sind, wenn der optische Leistungswert unter dem voreingestellten Schwellenwert liegt; und den aktuell erfassten optischen Leistungswert mit dem zuletzt erfassten optischen Leistungswert zu vergleichen, wobei, falls der aktuell erfasste optische Leistungswert kleiner ist als der zuletzt erfasste optische Leistungswert, der aktuelle optische Leistungswert als ungültig gekennzeichnet wird, andernfalls der aktuelle optische Leistungswert als gültig gekennzeichnet wird;
wobei, wenn die aktuelle optische Leistung unter dem Schwellenwert liegt, das FPGA-Gerät (107) konfiguriert ist, den Timer zu starten, wenn eine Zeitdauer einen festgelegten Wert überschreitet, die in einem Speicher innerhalb des FPGA-Geräts (107) gespeicherten Daten zur optischen Leistung zu aktualisieren und den Timer zurückzusetzen; und
wenn die aktuelle optische Leistung größer als der Schwellenwert ist, das FPGA-Gerät (107) konfiguriert ist, falls ein Aktualisierungsbefehl empfangen wird, die im Speicher innerhalb des FPGA-Geräts (107) gespeicherten Daten zur optischen Leistung zu aktualisieren; oder
wobei, wenn die aktuelle optische Leistung größer als der Schwellenwert und kleiner als eine zuletzt erfasste optische Leistung ist, das FPGA-Gerät (107) konfiguriert ist, den Timer zu starten, wenn eine Zeitdauer einen festgelegten Wert überschreitet, die in dem Speicher innerhalb des FPGA-Geräts (107) gespeicherten Daten zur optischen Leistung zu aktualisieren, und den Timer zurückzusetzen; oder wenn die aktuelle optische Leistung größer als der Schwellenwert und größer als die zuletzt erfasste optische Leistung ist, das FPGA-Gerät (107) konfiguriert ist, einen gleitenden Mittelwert der aktuellen optischen Leistung aus den aus früheren Erfassungen erhaltenen optischen Leistungen zu bilden, um einen aktuellen mittleren Leistungswert zu erhalten, anschließend die in dem Speicher innerhalb des FPGA-Geräts (107) gespeicherten Daten der optischen Leistung mit dem aktuellen mittleren Leistungswert zu aktualisieren (405) und den Timer zurückzusetzen; und
wobei das FPGA-Gerät (107) ferner konfiguriert ist, die Initialisierung einer Variablen und eines Speicherplatzes abzuschließen (501) und anschließend in einen Synchronisationssteuerungszustand zu wechseln (502), um sicherzustellen, dass ein Taktsignal und ein Steuersignal des Analog-Digital-Wandler-Chips (106) in jeder optischen Leistungserfassungsschaltung (101-109) vollständig identisch sind, sodass der Analog-Digital-Wandler-Chip (106) in jeder optischen Leistungserfassungsschaltung (101-190) gleichzeitig abtastet und eine strenge Taktsynchronisation der Daten intern durchgeführt wird, wodurch die optische Eingangs- und Ausgangsleistung gleichzeitig ermittelt wird,
das FPGA ferner so konfiguriert ist, eine Gültigkeit einer erfassten optischen Eingangsleistung und einer optischen Ausgangsleistung zu bestimmen (507);
wobei, wenn die erfasste optische Eingangsleistung oder die erfasste optische Ausgangsleistung unter einem Schwellenwert liegt, das FPGA-Gerät (107) ferner konfiguriert ist, anzuzeigen, dass ein ungültiger Wert erfasst wurde, und einen Timer des FPGAs zu starten (508); falls eine Zeitdauer überschritten wird (509), Verstärkungsdaten zu aktualisieren (510) und gleichzeitig einen aktuellen Verstärkungswert als ungültigen Wert anzuzeigen, den Timer zurückzusetzen (515) und einen nächsten Verstärkungserfassungsprozess durchzuführen; und
wobei, wenn die erfasste optische Eingangsleistung oder die optische Ausgangsleistung größer als der Schwellenwert ist, das FPGA-Gerät (107) ferner konfiguriert ist, anzuzeigen, dass ein gültiger Wert erfasst wurde, und festzustellen, ob ein Aktualisierungsbefehl empfangen wurde (511), wenn der Aktualisierungsbefehl empfangen wurde, die Verstärkungsdaten sofort zu aktualisieren (510), andernfalls die Verstärkung des optischen Verstärkers aus der optischen Eingangsleistung und der optischen Ausgangsleistung zu berechnen (512), die Verstärkungsdaten zu speichern (513), eine gleitende Mittelwertbildung durchzuführen (514) und die Verstärkungsdaten mit den Daten nach Durchführung der gleitenden Mittelwertbildung zu aktualisieren (514), den Timer zurückzusetzen (515) und einen nächsten Verstärkungserfassungsprozess durchzuführen.

2. Vorrichtung zur Erfassung optischer Leistung und Verstärkung eines optischen Verstärkers in einem Burst-Modus nach Anspruch 1, **dadurch gekennzeichnet, dass**
die Temperaturerfassungsschaltung (108) einen Temperatursensor umfasst, der so konfiguriert ist, dass er die Temperatur des optischen Verstärkers (202) erfasst, die erfasste Temperatur in ein digitales Signal umwandelt und das digitale Signal anschließend an das FPGA-Gerät (107) überträgt, und
das FPGA-Gerät (107) ferner so konfiguriert ist, dass es die ermittelte optische Leistung und/oder Verstärkung auf der Grundlage des erfassten Temperaturwerts kompensiert.

3. Vorrichtung zum Erfassen optischer Leistung und Verstärkung eines optischen Verstärkers im Burst-Modus nach Anspruch 1, **dadurch gekennzeichnet, dass** das FPGA-Gerät (107) ferner eine Kommunikationsschnittstelle zum Einstellen eines Leistungsschwellenwerts, eines Zeitintervalls eines Zeitgebers und eines Temperaturkompensationskoeffizienten umfasst.

4. Vorrichtung zur Erfassung optischer Leistung und Verstärkung eines optischen Verstärkers im Burst-Modus nach Anspruch 1, **dadurch gekennzeichnet, dass** der optische Verstärker (202) ein Raman-Faserverstärker, ein Erbium-dotierter Faserverstärker, ein Ytterbium-dotierter Faserverstärker, ein Hybrid-Faserverstärker oder ein Hochleistungs-Faserverstärker ist.

5. Vorrichtung zur Erfassung optischer Leistung und Verstärkung eines optischen Verstärkers im Burst-Modus nach Anspruch 1, **dadurch gekennzeichnet, dass**
das FPGA-Gerät (107) ferner konfiguriert ist, ein von jeder optischen Leistungserfassungsschaltung (101-109) erfasstes analoges Signal zu empfangen, das durch den Analog-Digital-Wandler-Chip (106) in ein digitales Signal umgewandelt und an das FPGA-Gerät (107) übertragen wird, und die tatsächliche optische Leistung auf der Grundlage eines in einer Parametertabelle vorab gespeicherten Kalibrierungskoeffizienten zu berechnen;
wenn die tatsächliche optische Leistung einen festgelegten Schwellenwert überschreitet, das FPGA-Gerät (107) ferner so konfiguriert ist, eine Erkennungszustandsmaschine innerhalb des FPGA-Geräts (107) auszulösen, einen gleitenden Mittelwert der gültigen optischen Leistung zu bilden, einen gültigen Wert davon aufzuzeichnen und gleichzeitig eine Leistungsbestimmung durchzuführen; und nur wenn ein zu diesem Zeitpunkt erfasster optischer Leistungswert einen zuletzt erfassten optischen Leistungswert überschreitet, das FPGA-Gerät (107) ferner konfiguriert ist, einen numerischen Wert in einem Speicher innerhalb des FPGA-Geräts (107) zu aktualisieren, andernfalls den zu diesem Zeitpunkt erfassten optischen Leistungswert zu verwerfen, sodass sichergestellt ist, dass in dem Speicher innerhalb des FPGA-Geräts (107) der maximale optische Leistungswert in dem Burst-Modus gespeichert ist.

6. Vorrichtung zum Erfassen optischer Leistung und Verstärkung eines optischen Verstärkers im Burst-Modus nach Anspruch 5, **dadurch gekennzeichnet, dass**, wenn der numerische Wert im Speicher innerhalb des FPGA-Geräts (107) aktualisiert wird, das FPGA-Gerät (107) so konfiguriert ist, dass es den Timer zur Zeitmessung startet, und wenn eine Zeitdauer einen festgelegten Wert überschreitet oder ein Aktualisierungsbefehl von dem FPGA-Gerät (107) über eine Kommunikationsschnittstelle empfangen wird, das FPGA-Gerät (107) so konfiguriert ist, dass es den numerischen Wert im Speicher innerhalb des FPGA-Geräts (107) erneut aktualisiert.

7. Vorrichtung zum Erfassen optischer Leistung und Verstärkung eines optischen Verstärkers in einem Burst-Modus nach Anspruch 1, **dadurch gekennzeichnet, dass** das FPGA-Gerät (107) ferner eine Temperaturkompensations-Parametertabelle umfasst, um von der Temperaturerfassungsschaltung (108) eingegebene Temperaturdaten zur Kompensation einer Berechnung der optischen Leistung zu verwenden.

8. Verfahren zur Erfassung optischer Leistung eines optischen Verstärkers mittels der Vorrichtung zur Erfassung optischer Leistung und Verstärkung des optischen Verstärkers im Burst-Modus nach einem der Ansprüche 1 bis 7, **dadurch gekennzeichnet, dass** es umfasst:
Schritt 401, Initialisieren eines optischen Leistungserfassungsmoduls, in einem Anfangszustand, Konfigurieren eines Analog-Digital-Wandler-Chips (106) in jeder optischen Leistungserfassungsschaltung (101-109) durch ein FPGA-Gerät (107) und, nachdem die Konfiguration abgeschlossen ist, Fortfahren zu Schritt 402;
Schritt 402, Starten einer ADC-Abtastung, kontinuierliches Abtasten und Ausgeben umgewandelter optischer Leistungsdaten an das FPGA-Gerät (107) durch den Analog-Digital-Wandler-Chip (106) sowie Weitergehen zu Schritt 403;
Schritt 403, Auslesen der von dem Analog-Digital-Wandler-Chip (106) eingegebenen Abtastdaten durch das FPGA-Gerät (107), Berechnen der aktuell erfassten optischen Leistung durch das FPGA-Gerät (107) und Weitergehen zu Schritt 404;
Schritt 404, Feststellen, ob ein Datenaktualisierungsvorgang durchgeführt werden soll, indem ermittelt wird, ob ein Datenaktualisierungsbefehl empfangen wurde; falls der Datenaktualisierungsbefehl empfangen wurde, Weitergehen zu Schritt 405, andernfalls Weitergehen zu Schritt 406;
Schritt 405, Aktualisieren von Daten mit einem aktuellen optischen Leistungswert und Zurückkehren zu Schritt 404;
Schritt 406, Vergleichen des vom FPGA-Gerät (107) berechneten optischen Leistungswerts mit einem voreingestellten Schwellenwert; wenn der optische Leistungswert kleiner als der voreingestellte Schwellenwert ist, anzeigend, dass das, was zu diesem Zeitpunkt durch die Abtastung erfasst wird, sich in einem Zustand ohne optisches Signal befindet und die Daten ungültig sind, Weitergehen zu Schritt 407; wenn der Leistungswert den voreingestellten Schwellenwert überschreitet, anzeigend, dass das, was bei der Abtastung zu diesem Zeitpunkt erfasst wird, sich in einem Zustand mit optischem Signal befindet, Weitergehen zu Schritt 408;
Schritt 407, Starten der Zeitmessung eines internen Timers und anschließender Übergang zu Schritt 409;
Schritt 408, Vergleichen des aktuell erfassten optischen Leistungswerts mit dem zuletzt erfassten optischen Leistungswert, falls der aktuell erfasste optische Leistungswert kleiner ist als der zuletzt erfasste optische Leistungswert, wird der aktuelle optische Leistungswert als ungültig betrachtet und es wird mit Schritt 407 fortgefahren, andernfalls wird der aktuelle optische Leistungswert als gültig betrachtet und es wird mit Schritt 410 fortgefahren;
Schritt 409, Feststellen, ob eine Laufzeit des internen Timers eine voreingestellte Verzögerungszeit erreicht, wenn die voreingestellte Verzögerungszeit erreicht ist, Weitergehen zu Schritt 411; andernfalls Weitergehen zu Schritt 404;
Schritt 410, Durchführen eines gleitenden Durchschnitts aus dem aktuell erfassten optischen Leistungswert mit dem optischen Leistungswerten, der von letzten N Erfassungen erhalten wird, um den aktuellen optischen Leistungswert zu ermitteln und den Einfluss von Rauschstörung zu verringern, und anschließend wird mit Schritt 411 fortgefahren;
Schritt 411, Zurücksetzen des internen Timers und Weitergehen zu Schritt 405.

9. Verfahren zum Erfassen optischer Leistung eines optischen Verstärkers im Burst-Modus nach Anspruch 8, **dadurch gekennzeichnet, dass** das FPGA-Gerät (107) eine Temperaturkompensationskoeffiziententabelle (602) in Form einer Nachschlagetabelle speichert, einen Kompensationskoeffizienten (604) durch Nachschlagen in der Temperaturkompensationskoeffiziententabelle (602) entsprechend den von einer Temperaturerfassungsschaltung (108) eingegebenen Temperaturdaten ermittelt, und den Kompensationskoeffizienten (604) mit dem aktuell erfassten Leistungswert (605) multipliziert, um einen tatsächlichen optischen Leistungswert (606) bei der aktuellen Temperatur zu erhalten.

10. Verfahren zum Erfassen von Verstärkung eines optischen Verstärkers durch die Vorrichtung zum Erfassen von optischer Leistung und Verstärkung des optischen Verstärkers in einem Burst-Modus gemäß einem der Ansprüche 1 bis 7, **dadurch gekennzeichnet, dass** es umfasst:
Vervollständigen (501) einer Initialisierung einer Variablen und eines Speicherbereichs durch ein FPGA-Gerät (107) und anschließendes Einleiten (502) eines Synchronisationssteuerungszustands durch das FPGA-Gerät (107), um sicherzustellen, dass ein Taktsignal und ein Steuersignal des ADC-Analog-Digital-Wandler-Chips (106) in jeder optischen Leistungserfassungsschaltung (101-109) vollständig identisch sind, sodass jeder Analog-Digital-Wandler-Chip (106) in jeder optischen Leistungserfassungsschaltung (101-109) gleichzeitig abtastet und eine strenge Taktsynchronisation der Daten intern durchgeführt wird und die optische Eingangs- und Ausgangsleistung gleichzeitig ermittelt wird;
Bestimmen (507) einer Gültigkeit einer erfassten optischen Eingangsleistung und einer erfassten optischen Ausgangsleistung durch das FPGA-Gerät (107);
wenn die erfasste optische Eingangsleistung oder die erfasste optische Ausgangsleistung unter einem Schwellenwert liegt, was darauf hinweist, dass ein ungültiger Wert erfasst wurde, und Starten (508) eines Timers; wenn eine Zeitgrenze überschritten wird (509), Aktualisieren (510) von Verstärkungsdaten und gleichzeitig Anzeigen eines aktuellen Verstärkungswerts als ungültige Daten, Zurücksetzen (515) des Timers und Durchführen eines nächsten Verstärkungserfassungsprozesses;
wenn die erfasste optische Eingangsleistung oder optische Ausgangsleistung größer als der Schwellenwert ist, was darauf hinweist, dass ein gültiger Wert erfasst wird, und es festgestellt wird, ob ein Aktualisierungsbefehl empfangen wurde (511), wenn der Aktualisierungsbefehl empfangen wird, sofortiges Aktualisieren (510) der Verstärkungsdaten, andernfalls Berechnen (512) der Verstärkung des optischen Verstärkers aus der optischen Eingangsleistung und der optischen Ausgangsleistung, Speichern (513) der Verstärkungsdaten, Durchführen (514) eines gleitenden Durchschnitts und Aktualisieren (510) der Verstärkungsdaten mit den Daten nach Durchführung des gleitenden Durchschnitts, Zurücksetzen (515) des Timers und Durchführen eines nächsten Verstärkungserfassungsprozesses.

## Revendications

1. Appareil pour détecter la puissance optique et le gain d'un amplificateur optique en mode rafale, comprenant: plusieurs circuits de détection de puissance optique (101-109), un dispositif FPGA (107) et un circuit de détection de température (108);
dans lequel chaque circuit de détection de puissance optique (101-109) présente la même structure et le même mode de mise en œuvre, et comprend un convertisseur photoélectrique (102), un amplificateur à transimpédance (103), un circuit de conditionnement de signal analogique (104), un filtre (105) et une puce de conversion analogique-numérique (106), qui sont tous indépendants les uns des autres;
dans chaque circuit de détection de puissance optique (101-109), le convertisseur photoélectrique (102) est configuré pour convertir un signal optique d'un chemin optique respectif en un signal de courant, l'amplificateur à transimpédance (103) est configuré pour convertir le signal de courant émis par le convertisseur photoélectrique (102) en un signal de tension, le circuit de conditionnement de signal analogique (104) est configuré pour corriger le signal de tension émis par l'amplificateur à transimpédance (103), pour amplifier et convertir le signal de tension pour ajuster son amplitude à une plage adaptée à la puce de conversion analogique-numérique (106), le filtre (105) est configuré pour éliminer un signal d'interférence à haute fréquence dans le signal de tension émis par le circuit de conditionnement de signal analogique (104), la puce de conversion analogique-numérique (106) est configurée pour convertir le signal de tension analogique filtré en un signal numérique et le transmettre au dispositif FPGA (107); le dispositif FPGA (107) est configuré pour calculer la puissance optique actuelle et le gain de chaque chemin optique à partir du signal numérique appliqué par le chemin optique correspondant, et
dans lequel le dispositif FPGA (107) est muni d'un temporisateur et le dispositif FPGA (107) est configuré pour comparer la valeur de puissance optique calculée par le dispositif FPGA (107) à un seuil prédéfini, et ensuite pour indiquer que ce qui est détecté par l'échantillonnage à ce moment-là se trouve dans un état sans signal optique et que les données ne sont pas valides lorsque la valeur de puissance optique est inférieure au seuil prédéfini; et pour comparer la valeur de puissance optique actuellement détectée à la valeur de puissance optique détectée la fois précédente; si la valeur de puissance optique actuellement détectée est inférieure à la valeur de puissance optique détectée la fois précédente, pour indiquer que la valeur de puissance optique actuelle n'est pas valide, sinon pour indiquer que la valeur de puissance optique actuelle est valide;
lorsque la puissance optique actuelle est inférieure au seuil, le dispositif FPGA (107) est configuré pour démarrer le temporisateur; si un temps de temporisation dépasse une valeur définie, pour mettre à jour les données relatives à la puissance optique stockées dans une mémoire interne au dispositif FPGA (107), puis pour réinitialiser le temporisateur; et
lorsque la puissance optique actuelle est supérieure au seuil, si une commande de mise à jour est reçue, le dispositif FPGA (107) est configuré pour mettre à jour les données relatives à la puissance optique stockées dans la mémoire interne du dispositif FPGA (107); ou
lorsque la puissance optique actuelle est supérieure au seuil et inférieure à une puissance optique détectée la fois précédente, le dispositif FPGA (107) est configuré pour démarrer le temporisateur; si un temps de temporisation dépasse une valeur définie, pour mettre à jour les données relatives à la puissance optique stockées dans la mémoire interne du dispositif FPGA (107), et pour réinitialiser le temporisateur; ou lorsque la puissance optique actuelle est supérieure au seuil et supérieure à la puissance optique détectée la fois précédente, le dispositif FPGA (107) est configuré pour calculer une moyenne mobile de la puissance optique actuelle à partir des puissances optiques obtenues lors des détections précédentes afin d'obtenir une valeur de puissance optique moyenne actuelle, puis pour mettre à jour (405) les données de puissance optique stockées dans la mémoire interne du dispositif FPGA (107) à l'aide de la valeur de puissance optique moyenne actuelle, et pour réinitialiser le temporisateur; et
dans lequel le dispositif FPGA (107) est en outre configuré pour effectuer (501) l'initialisation d'une variable et d'un espace de stockage, et puis pour passer (502) à un état de commande de synchronisation afin de garantir que le signal d'horloge et le signal de commande de la puce de conversion analogique-numérique (106) dans chaque circuit de détection de puissance optique (101-109) soient parfaitement identiques, de sorte que la puce de conversion analogique-numérique (106) dans chaque circuit de détection de puissance optique (101-109) effectue un échantillonnage simultané, et une synchronisation stricte d'horloge soit assurée en interne sur les données, et que les puissances optiques d'entrée et de sortie soient obtenues simultanément,
le FPGA est en outre configuré pour déterminer (507) la validité d'une puissance optique d'entrée et d'une puissance optique de sortie détectées;
lorsque la puissance optique d'entrée ou la puissance optique de sortie détectées est inférieure à un seuil, le dispositif FPGA (107) est en outre configuré pour indiquer qu'une valeur non valide a été détectée, et pour démarrer (508) un temporisateur du FPGA; si un temps de temporisation est dépassé (509), pour mettre à jour (510) les données de gain et, simultanément, pour indiquer la valeur de gain actuelle comme étant une donnée invalide, pour réinitialiser (515) le temporisateur, puis pour effectuer un processus de détection de gain suivant; et
lorsque la puissance optique d'entrée ou la puissance optique de sortie détectée est supérieure au seuil, le dispositif FPGA (107) est en outre configuré pour indiquer qu'une valeur valide a été détectée, et pour déterminer si une commande de mise à jour a été reçue (511); si la commande de mise à jour est reçue, pour mettre à jour (510) immédiatement les données de gain; sinon, pour calculer (512) le gain de l'amplificateur optique à partir de la puissance optique d'entrée et de la puissance optique de sortie, pour stocker (513) les données de gain, pour effectuer (514) une moyenne mobile, puis pour mettre à jour (510) les données de gain avec les données obtenues après avoir effectué la moyenne mobile, pour réinitialiser (515) le temporisateur et pour effectuer un processus de détection de gain suivant.

2. Appareil pour détecter la puissance optique et le gain d'un amplificateur optique en mode rafale selon la revendication 1, **caractérisé en ce que**,
le circuit de détection de température (108) comprend un capteur de température qui est configuré pour détecter la température de l'amplificateur optique (202), pour convertir la température détectée en un signal numérique, et pour transmettre le signal numérique au dispositif FPGA (107), et
le dispositif FPGA (107) est en outre configuré pour compenser la puissance optique et/ou le gain obtenus en fonction de la valeur de température détectée.

3. Appareil pour détecter la puissance optique et le gain d'un amplificateur optique en mode rafale selon la revendication 1, **caractérisé en ce que**, le dispositif FPGA (107) comprend en outre une interface de communication permettant de définir un seuil de puissance, un intervalle de temps d'un temporisateur et un coefficient de compensation de température.

4. Appareil pour détecter la puissance optique et le gain d'un amplificateur optique en mode rafale selon la revendication 1, **caractérisé en ce que**, l'amplificateur optique (202) est un amplificateur à fibre Raman, un amplificateur à fibre dopée à l'erbium, un amplificateur à fibre dopée à l'ytterbium, un amplificateur à fibre hybride ou un amplificateur à fibre haute puissance.

5. Appareil pour détecter la puissance optique et le gain d'un amplificateur optique en mode rafale selon la revendication 1, **caractérisé en ce que**,
le dispositif FPGA (107) est en outre configuré pour recevoir un signal analogique détecté par chaque circuit de détection de puissance optique (101-109), qui est converti en un signal numérique par la puce de conversion analogique-numérique (106) puis transmis au dispositif FPGA (107), et pour calculer la puissance optique réelle à partir d'un coefficient d'étalonnage stocké au préalable dans une table de paramètres;
lorsque la puissance optique réelle dépasse un seuil défini, le dispositif FPGA (107) est en outre configuré pour déclencher une machine à états de détection dans le dispositif FPGA (107), pour calculer une moyenne mobile de la puissance optique valide, pour enregistrer une valeur valide de celle-ci et pour effectuer simultanément une détermination de puissance; et uniquement lorsque la valeur de puissance optique détectée à ce moment-là dépasse la valeur de puissance optique détectée la fois précédente, le dispositif FPGA (107) est en outre configuré pour mettre à jour une valeur numérique dans une mémoire située à l'intérieur du dispositif FPGA (107), sinon, à ignorer la valeur de puissance optique détectée à ce moment-là, de manière à garantir que ce qui est stocké dans la mémoire interne du dispositif FPGA (107) correspond à la valeur maximale de puissance optique en mode rafale.

6. Appareil pour détecter la puissance optique et le gain d'un amplificateur optique en mode rafale selon la revendication 5, **caractérisé en ce que**, lorsque la valeur numérique stockée dans la mémoire interne du dispositif FPGA (107) est mise à jour, le dispositif FPGA (107) est configuré pour démarrer le temporisateur afin de mesurer le temps, et lorsqu'un temps de temporisation dépasse une valeur définie, ou lorsqu'une commande de mise à jour est reçue par le dispositif FPGA (107) par le biais d'une interface de communication, le dispositif FPGA (107) est configuré pour mettre à jour à nouveau la valeur numérique stockée dans la mémoire interne du dispositif FPGA (107).

7. Appareil pour détecter la puissance optique et le gain d'un amplificateur optique en mode rafale selon la revendication 1, **caractérisé en ce que**, le dispositif FPGA (107) comprend en outre une table de paramètres de compensation de température permettant d'utiliser les données de température entrées par le circuit de détection de température (108) afin de compenser le calcul de la puissance optique.

8. Procédé de détection de puissance optique et d'un gain d'un amplificateur optique par l'appareil pour détecter la puissance optique et le gain de l'amplificateur optique en mode rafale selon l'une quelconque des revendications 1 à 7, **caractérisé en ce qu'**il comprend:
étape 401, initialisation d'un module de détection de puissance optique; dans un état initial, configuration d'une puce de conversion analogique-numérique (106) dans chaque circuit de détection de puissance optique (101-109) par un dispositif FPGA (107); une fois la configuration terminée, passage à l'étape 402;
étape 402, lancement de l'échantillonnage CAN, l'échantillonnage en continu et transmission des données de puissance optique converties au dispositif FPGA (107) par la puce de conversion analogique-numérique (106), passage à l'étape 403;
étape 403, lecture, par le dispositif FPGA (107), des données d'échantillonnage entrées par la puce de conversion analogique-numérique (106); calcul, par le dispositif FPGA (107), de la puissance optique actuellement détectée; et passage à l'étape 404;
étape 404, détermination visant à savoir s'il convient d'effectuer une opération de mise à jour des données en vérifiant si une commande de mise à jour des données a été reçue; si les données de mise à jour sont reçues, passage à l'étape 405; dans le cas contraire, passage à l'étape 406;
étape 405, mise à jour des données avec la valeur actuelle de la puissance optique, puis retour à l'étape 404;
étape 406, comparaison de la valeur de puissance optique calculée par le dispositif FPGA (107) à un seuil prédéfini; si la valeur de puissance optique est inférieure au seuil prédéfini, indication que ce qui est détecté par l'échantillonnage à ce moment-là se trouve dans un état sans signal optique et que les données ne sont pas valides, passage à l'étape 407; si la valeur de puissance dépasse le seuil prédéfini, indication que ce qui est détecté par l'échantillonnage à ce moment-là se trouve dans un état de signal optique, passage à l'étape 408;
étape 407, démarrage d'une temporisation de temporisateur interne, puis passage à l'étape 409;
étape 408, comparaison de la valeur de puissance optique actuellement détectée à la valeur de puissance optique détectée précédemment; si la valeur de puissance optique actuellement détectée est inférieure à la valeur de puissance optique détectée précédemment, la valeur de puissance optique actuelle étant alors considérée comme non valide, passer à l'étape 407; dans le cas contraire, la valeur de puissance optique actuelle étant considérée comme valide, passage à l'étape 410;
étape 409, détermination visant à savoir si la durée de temporisation du temporisateur interne atteint un délai prédéfini; si le délai est atteint, passage à l'étape 411 ; sinon, passage à l'étape 404 ;
étape 410, calcul d'une moyenne mobile de la valeur de puissance optique actuellement détectée et de la valeur de puissance optique obtenue à partir de N détections précédentes afin d'obtenir la valeur de puissance optique actuelle et de réduire ainsi l'influence des interférences dues au bruit, puis passage à l'étape 411;
étape 411, réinitialisation du temporisateur interne, puis passage à l'étape 405.

9. Procédé de détection de puissance optique et d'un gain d'un amplificateur optique en mode par rafales selon la revendication 8, **caractérisé en ce que** le dispositif FPGA (107) stocke une table de coefficients de compensation de température (602) sous la forme d'une table de consultation, obtient un coefficient de compensation (604) en consultant la table de coefficients de compensation de température (602) en fonction des données de température entrées par un circuit de détection de température (108), et multiplie le coefficient de compensation (604) par la valeur de puissance actuellement détectée (605) afin d'obtenir une valeur de puissance optique réelle (606) à la température actuelle.

10. Procédé de détection de puissance optique et d'un gain d'un amplificateur optique par le dispositif de détection de la puissance optique et du gain de l'amplificateur optique en mode rafale selon l'une quelconque des revendications 1 à 7, **caractérisé en ce qu'**il comprend:
la réalisation (501), par un dispositif FPGA (107), de l'initialisation d'une variable et d'un espace de stockage, et puis le passage (502), par le dispositif FPGA (107), à un état de commande de synchronisation afin de garantir qu'un signal d'horloge et un signal de commande de la puce de conversion analogique-numérique CAN (106) dans chaque circuit de détection de puissance optique (101-109) soient parfaitement identiques, de sorte que la puce de conversion analogique-numérique (106) dans chaque circuit de détection de puissance optique (101-109) effectue un échantillonnage simultané, et une synchronisation stricte d'horloge soit assurée en interne sur les données, et que les puissances optiques d'entrée et de sortie sont obtenues simultanément; la détermination (507), par le dispositif FPGA (107), de la validité d'une puissance optique d'entrée et d'une puissance optique de sortie détectées;
lorsque la puissance optique d'entrée ou la puissance optique de sortie détectées est inférieure à un seuil, l'indication qu'une valeur non valide a été détectée, et le démarrage (508) d'un temporisateur; si un temps de temporisation est dépassé (509), la mise à jour (510) des données de gain et, simultanément, l'indication que la valeur de gain actuelle est une donnée invalide, la régionalisation (515) du temporisateur, puis la réalisation d'un processus de détection de gain suivant; et
lorsque la puissance optique d'entrée ou la puissance optique de sortie détectée est supérieure au seuil, l'indication qu'une valeur valide a été détectée, et la détermination visant à savoir si une commande de mise à jour a été reçue (511); si la commande de mise à jour est reçue, la mise à jour (510) immédiate des données de gain; sinon, le calcul (512) du gain de l'amplificateur optique à partir de la puissance optique d'entrée et de la puissance optique de sortie, le stockage (513) des données de gain, le calcul (514) d'une moyenne mobile, et la mise à jour (510) des données de gain avec les données obtenues après avoir effectué la moyenne mobile, pour réinitialiser (515) le temporisateur et pour la réalisation d'un processus de détection de gain suivant.
